(19) Europäisches Patentamt

European Patent Office

Office européen des brevets

(11) **EP 0 779 702 B1**

(12) **EUROPÄISCHE PATENTSCHRIFT**

(45) Veröffentlichungstag und Bekanntmachung des Hinweises auf die Patenterteilung:
**15.02.2006 Patentblatt 2006/07**

(51) Int Cl.:
*H02M 7/538* *(2006.01)*    *H02M 3/156* *(2006.01)*

(21) Anmeldenummer: **96118168.2**

(22) Anmeldetag: **13.11.1996**

(54) **Elektrische Schaltungsanordnung zur Umformung einer Eingangsspannung**

Electric circuit for converting an input voltage

Circuit pour la conversion d'une tension d'entrée

(84) Benannte Vertragsstaaten:
**FR GB IT**

(30) Priorität: **16.12.1995 DE 19547155**

(43) Veröffentlichungstag der Anmeldung:
**18.06.1997 Patentblatt 1997/25**

(73) Patentinhaber: **Bosch Rexroth AG**
**97816 Lohr am Main (DE)**

(72) Erfinder: **Panzer, Karlheinz**
**97525 Schwebheim (DE)**

(56) Entgegenhaltungen:
**US-A- 5 177 676      US-A- 5 311 548**
**US-A- 5 568 044**

EP 0 779 702 B1

## Beschreibung

Die Erfindung betrifft eine elektrische Schaltungsanordnung zur Umformung einer Eingangsspannung in eine eingeprägte elektrische Ausgangsgröße gemäß dem Oberbegriff des Anspruchs 1.

Es sind elektrische Schaltungsanordnungen bekannt, die eine Eingangsspannung entweder in eine eingeprägte Ausgangsspannung oder in einen eingeprägten Ausgangsstrom umformen, wobei zwischen der Eingangsspannung und der elektrischen Ausgangsgröße eine vorgegebene Zuordnung besteht. In den meisten Fällen besteht zwischen der Eingangsspannung und der elektrischen Ausgangsgröße ein linearer Zusammenhang. Derartige Schaltungsanordnungen werden zum Übertragen von Informationen in Form von analogen Strom- oder Spannungssignalen eingesetzt. Üblicherweise wird dabei für Stromsignale ein Bereich von - 20 mA bis + 20 mA verwendet, während für Spannungssignale ein Bereich von - 10 V bis + 10 V verwendet wird. Der Widerstand, mit dem das in der Übertragungskette nachgeschaltete Übertragungsglied den Ausgang der vorgeschalteten Schaltungsanordnung belastet, ist bei einem Stromeingang kleiner oder gleich 500 Ω. In der Regel beträgt er 100 Ω. Bei diesem Wert kann der Betrag der Ausgangsspannung nicht größer als 2 V werden. Der Widerstand, mit dem das in der Übertragungskette nachgeschaltete Übertragungsglied den Ausgang der vorgeschalteten Schaltungsanordnung belastet, ist bei einem Spannungseingang größer als 10 kΩ. In der Regel beträgt er 50 kΩ. Bei diesem Wert des kann der Betrag des Ausgangsstromes nicht größer als 0,2 mA werden.

Eine Einsatzmöglichkeit für derartige Schaltungsanordnungen sind Sollwertgeber zur Ansteuerung elektrischer Übertragungsglieder, z. B. elektrisch angesteuerte Stellglieder, wie hydraulische Stetigventile mit integrierter Ansteuerelektronik. Die Ansteuerelektronik dieser Stellglieder besitzt entweder einen Stromeingang oder einen Spannungseingang. Für die Ansteuerung eines Stellgliedes mit Stromeingang ist daher ein Sollwertgeber mit Stromausgang erforderlich, während für die Ansteuerung eines Stellgliedes mit Spannungseingang ein Sollwertgeber mit Spannungsausgang erforderlich ist.

Zur Inbetriebnahme von Regelkreisen und zur Fehlersuche in Regelkreisen werden Prüfgeräte verwendet, die u. a. Sollwertgeber zur Ansteuerung von Stellgliedern enthalten. Um mit demselben Prüfgerät sowohl Stellglieder mit Stromeingang als auch Stellglieder mit Spannungseingang ansteuern können, muß der in dem Prüfgerät enthaltene Sollwertgeber sowohl einen Stromausgang als auch einen Spannungsausgang aufweisen. Für den Anschluß des Stellgliedes an das Prüfgerät muß außerdem bekannt sein, ob das anzusteuernde Stellglied einen Stromeingang oder einen Spannungseingang besitzt. Erst dann kann der Eingang des Stellgliedes mit dem entsprechenden Ausgang des Sollwertgebers verbunden werden. Dabei läßt es sich nicht ausschließen, daß versehentlich der Eingang eines Stellgliedes mit Spannungseingang mit dem Stromausgang des Sollwertgebers oder der Eingang eines Stellgliedes mit Stromeingang mit dem Spannungsausgang des Sollwertgebers verbunden wird.

Aus der US-PS 5.177.677 ist eine Schaltungsanordnung zur Umformung einer Eingangsspannung in eine elektrische Ausgangsspannung bekannt. An den Ausgang der Schaltungsanordnung ist eine Last angeschlossen. Die Eingangsspannung wird mit einer aus der Ausgangsspannung abgeleiteten Spannung verknüpft. Zur Beeinflussung der Ausgangsimpedanz der Schaltungsanordnung ist zusätzlich eine Verknüpfung einer von dem Ausgangsstrom abgeleiteten Spannung mit der Eingangsspannung und der aus der Ausgangsspannung abgeleiteten Spannung vorgesehen. Die Verknüpfung erfolgt in der Eingangsstufe einer Regeleinrichtung. Der Eingangsstufe ist eine Ausgangsstufe nachgeschaltet, an die die Last angeschlossen ist. Dem invertierenden Eingang eines Operationsverstärkers, der die Eingangsstufe der Regeleinrichtung bildet, sind drei Signale zugeführt. Bei ihnen handelt es sich um eine als Sollwertsignal dienende Eingangsspannung, die dem Operationsverstärker über einen ohmschen Eingangswiderstand zugeführt ist, die Ausgangsspannung der Schaltungsanordnung, die dem Operationsverstärker über eine erste Rückführschaltung zugeführt ist, und eine weitere Spannung, die aus dem Ausgangsstrom der Schaltungsanordnung abgeleitet ist und die dem Operationsverstärker über eine zweite Rückführschaltung zugeführt ist. Die Ausgangsspannung und der Ausgangsstrom stellen sich in Abhängigkeit von der Größe der Last so ein, daß die Summe der durch die Rückführschaltungen bewerteten Spannungen gleich der durch den Eingangswiderstand bewerteten Eingangsspannung ist.

Aus der US-PS 4.438.498 ist eine elektrische Schaltungsanordnung bekannt, die einem an ihren Ausgang angeschlossenen Lastwiderstand eine eingeprägte elektrische Ausgangsgröße zuführt. Bei der dem Lastwiderstand zugeführten elektrischen Ausgangsgröße handelt es sich im Falle eines kleinen Lastwiderstands um einen Strom und im Falle eines großen Lastwiderstands um eine Spannung. Als Sollwert für den über den Lastwiderstand fließenden Strom dient eine erste einstellbare Eingangsspannung und als Sollwert für die an dem Lastwiderstand abfallende Spannung dient eine zweite einstellbare Eingangsspannung. Der Ausgang der Schaltungsanordnung ist über die Reihenschaltung eines hochohmigen Widerstands und eines niederohmigen Widerstands mit Bezugspotential verbunden, wobei der Lastwiderstand parallel zu dem hochohmigen Widerstand angeordnet ist. Der niederohmige Widerstand ist zwischen den einen Anschluß der aus dem hochohmigen Widerstand und dem Lastwiderstand gebildeten Parallelschaltung und Bezugspotential angeordnet. Die Schaltungsanordnung weist einen ersten Regelkreis für den Ausgangsstrom und einen zweiten Regelkreis für die Ausgangsspannung auf. Eine Auswahlschaltung führt einer für beide Regelkreise gemeinsamen Ausgangsstufe die Ausgangsspannung desjenigen Regelkreises zu, an dessen Eingangsstufe die kleinere Regelabweichung ansteht. Als Istwert für den Stromregelkreis dient die an dem niederohmigen Widerstand abfallende Spannung. Da über diesen Widerstand nicht nur der über den Lastwiderstand fließenden Strom fließt, dessen Größe geregelt werden soll, sondern zusätzlich auch der über den hochohmigen Widerstand fließende Strom, ist der Spannungsabfall an dem niederohmigen Widerstand immer größer als die als Sollwert für den Stromregelkreis dienende erste Eingangsspannung. Das bedeutet, daß anstelle des über den Lastwiderstand fließenden Stroms der über den niederohmigen Widerstand fließende Summenstrom geregelt wird. Damit ist der über den Lastwiderstand fließende Strom immer etwas kleiner als der eingestellte Sollwert des Stromregelkreises, der durch die erste Eingangsspannung bestimmt ist. Als Istwert für den Spannungsregelkreis dient die an der Reihenschaltung aus dem niederohmigen Widerstand und der Parallelschaltung von Lastwiderstand und hochohmigem Widerstand abfallende Spannung. Da die an der Reihenschaltung abfallende Spannung größer ist als die an dem Lastwiderstand abfallende Spannung, ist dementsprechend die Spannung an dem Lastwiderstand immer etwas kleiner als der eingestellte Sollwert des Spannungsregelkreises, der durch die zweite Eingangsspannung bestimmt ist. Wegen des zwischen dem Lastwiderstand und dem Bezugspotential angeordneten niederohmigen Widerstands ist es bei der bekannten Schaltungsanordnung nicht möglich, einen Anschluß des Lastwiderstands direkt mit Bezugspotential zu verbinden.

Der Erfindung liegt die Aufgabe zugrunde, eine elektrische Schaltungsanordnung der eingangs genannten Art zu schaffen, bei der der Lastwiderstand einseitig mit Bezugspotential verbindbar ist.

Diese Aufgabe wird durch die im Anspruch 1 gekennzeichneten Merkmale gelöst. Die erfindungsgemäße Schaltungsanordnung führt einem nachgeschalteten Übertragungsglied mit Stromeingang einen eingeprägten Strom und einem nachgeschalteten Übertragungsglied mit Spannungseingang eine eingeprägte Spannung zu, die auf das Bezugspotential bezogen ist. Beim Anschließen eines Übertragungsglieds an den Ausgang der Schaltungsanordnung muß daher nicht darauf geachtet werden, ob das nachgeschaltete Übertragungsglied einen Stromausgang und einen Spannungsausgang der Schaltungsanordnung benötigt. Die erfindungsgemäße Schaltungsanordnung läßt sich in vorteilhafter Weise als Sollwertgeber für hydraulische Stetigventile mit integrierter Ansteuerelektronik verwenden. Da ihr sowohl für die Spannungsregelung als auch für die Stromregelung dieselbe Eingangsspannung zugeführt ist, kann das Einstellglied für die Eingangsspannung sowohl für eine der Schaltungsanordnung nachgeschaltete Ansteuerelektronik mit Stromeingang als auch für eine der Schaltungsanordnung nachgeschaltete Ansteuerelektronik mit Spannungseingang direkt in Prozent des jeweiligen Maximalwerts skaliert werden.

Vorteilhafte Ausgestaltungen der Erfindung sind in den Unteransprüchen gekennzeichnet.

Die Erfindung wird im folgenden mit ihren weiteren Einzelheiten anhand von in den Zeichnungen dargestellten Ausführungsbeispielen näher erläutert. Es zeigen

Figur 1    eine schematische Darstellung einer elektrischen Schaltungsanordnung zur Umformung einer Eingangsspannung in eine eingeprägte elektrische Ausgangsgröße,

Figur 2    das Schaltbild einer ersten Schaltungsanordnung gemäß der Erfindung und

Figur 3    das Schaltbild einer gegenüber der Figur 2 erweiterten Schaltungsanordnung.

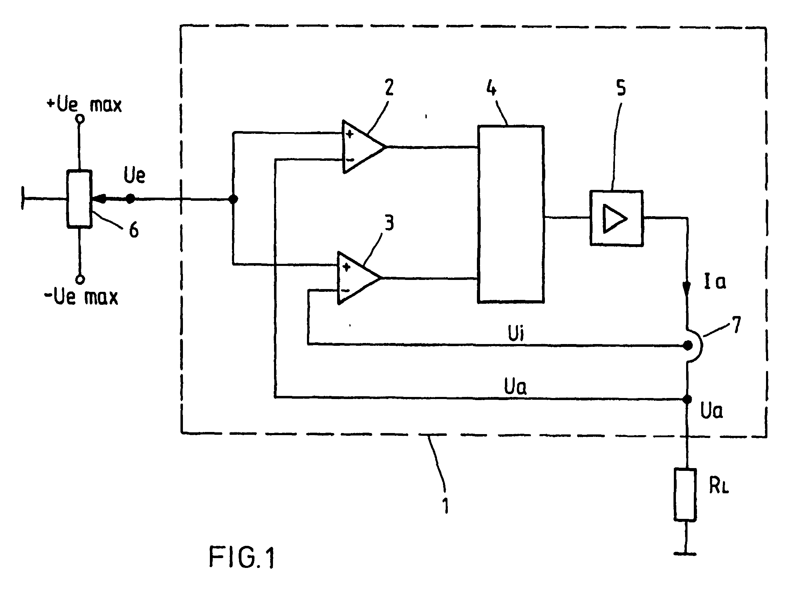

Die Figur 1 zeigt eine Schaltungsanordnung 1 zur Umformung einer Eingangsspannung in eine eingeprägte elektrische Ausgangsgröße in schematischer Darstellung. Die Eingangsstufen von zwei Regeleinrichtungen sind mit den Bezugszeichen 2 und 3 versehen. Die Eingangsstufe 2 ist einer Regeleinrichtung für die Ausgangsspannung der Schaltungsanordnung 1 zugeordnet und die Eingangsstufe 3 einer Regeleinrichtung für den Ausgangsstrom der Schaltungsanordnung 1. Eine Auswahlstufe 4 faßt die Ausgangssignale der Eingangsstufen 2 und 3 zusammen. Der Auswahlstufe 4 ist eine Ausgangsstufe 5 nachgeschaltet. Zwischen der Ausgangsstufe 5 und Bezugspotential ist ein mit $R_L$ bezeichneter Lastwiderstand angeordnet. Dieser Widerstand gehört nicht mehr zu der Schaltungsanordnung 1 sondern ist der Eingangswiderstand eines der Schaltungsanordnung 1 nachgeschalteten elektrischen Übertragungsgliedes, z. B. der Eingangswiderstand der Ansteuerelektronik eines hydraulischen Stetigventils mit integrierter Ansteuerelektronik. Der über den Lastwiderstand $R_L$ fließende Strom ist der Ausgangsstrom der Schaltungsanordnung 1. Er ist mit $I_a$ bezeichnet. An dem Lastwiderstand $R_L$ steht die mit $U_a$ bezeichnete Ausgangsspannung der Schaltungsanordnung 1 an. Die Ausgangsspannung $U_a$ ist das Produkt aus dem Ausgangsstrom $I_a$ der Schaltungsanordnung 1 und dem Lastwiderstand $R_L$.

Der Eingangsstufe 2 der ersten Regeleinrichtung und der Eingangsstufe 3 der zweiten Regeleinrichtung ist eine an einem Potentiometer 6 abgegriffene Eingangsspannung $U_e$ als Sollwertsignal zugeführt. Die Eingangsspannung $U_e$ kann in Abhängigkeit von der Stellung des Schleifers des Potentiometers 6 Werte zwischen $-U_{emin}$ und $+U_{emax}$ annehmen. Der Eingangsstufe 2 der ersten Regeleinrichtung ist die Ausgangsspannung $U_a$ der Schaltungsanordnung 1 als Istwertsignal zugeführt. Sie bildet aus der Eingangsspannung $U_e$ und der Ausgangsspannung $U_a$ eine erste Regelabweichung für die Regelung der Ausgangsspannung. Der Eingangsstufe 3 der zweiten Regeleinrichtung ist eine Spannung $U_i$ als Istwertsignal zugeführt. Die Spannung $U_i$ ist das Ausgangssignal einer Strommeßeinrichtung 7, die den Ausgangsstrom $I_a$ in eine diesem proportionale Spannung umformt. Die Eingangsstufe 3 der zweiten Regeleinrichtung bildet aus der Eingangsspannung $U_e$ und der Spannung $U_i$ eine zweite Regelabweichung für die Regelung des Ausgangsstroms.

Bei einem kleinen Lastwiderstand $R_L$, entsprechend einem Stromausgang, erreicht der Ausgangsstrom seinen Sollwert bevor die Ausgangsspannung ihren Sollwert erreicht hat. Dagegen erreicht bei einem großen Lastwiderstand $R_L$, entsprechend einem Spannungsausgang, die Ausgangsspannung ihren Sollwert bevor der Ausgangsstrom seinen Sollwert erreicht hat. Das bedeutet, daß sich in Abhängigkeit von der Größe des Lastwiderstandes $R_L$ immer nur eine der beiden Regeleinrichtungen in ihrem Arbeitsbereich befindet, während die Regelabweichung der jeweils anderen Regeleinrichtung noch sehr groß ist. Die Auswahlstufe 4 führt das Ausgangssignal derjenigen Eingangsstufe 2 oder 3, die sich in ihrem Arbeitsbereich befindet, der Ausgangsstufe 5 zu. Damit ist immer nur einer der beiden Regelkreise für Strom und Spannung wirksam. Bei einem kleinen Lastwiderstand $R_L$ ist der Regelkreis für den Ausgangsstrom wirksam, während bei einem großen Lastwiderstand $R_L$ der Regelkreis für die Ausgangsspannung wirksam ist.

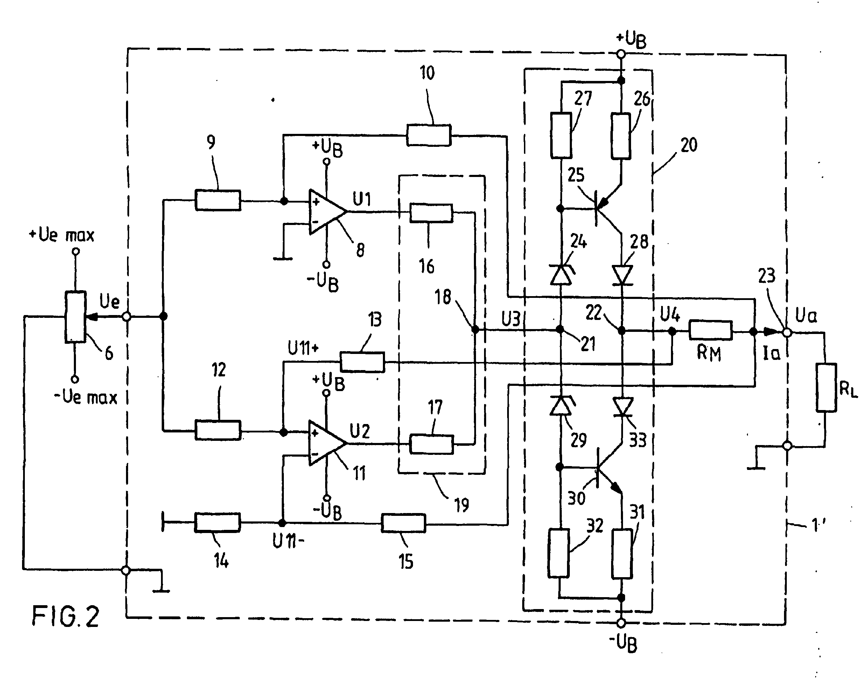

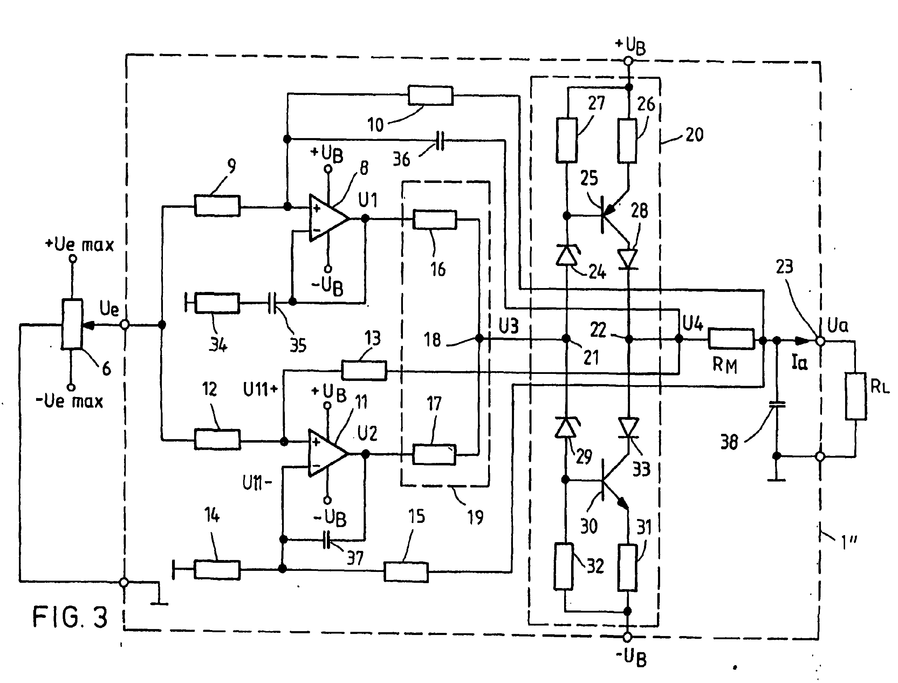

Es ist nicht erforderlich, daß das Ausgangssignal der Strommeßeinrichtung - wie in der Figur 1 dargestellt - eine auf Bezugspotential bezogene Spannung ist. In den Figuren 2 und 3 ist die Strommeßeinrichtung als Meßwiderstand $R_M$ ausgebildet, über den der Ausgangsstrom $I_a$ der Schaltungsanordnung fließt. Wie unten in Zusammenhang mit den Figuren 2 und 3 noch im einzelnen ausgeführt ist, wird erst in der Eingangsstufe der Regeleinrichtung für den Ausgangsstrom die dem Ausgangsstrom $I_a$ entsprechende Differenz aus den Spannungen an den Anschlußpunkten des Meßwiderstandes $R_M$ ausgewertet.

Die Figur 2 zeigt das Schaltbild einer ersten erfindungsgemäßen Schaltungsanordnung 1', die von der schematischen Darstellung in der Figur 1 ausgeht. Die Eingangsstufe für den Spannungsregelkreis enthält einen Operationsverstärker 8. Der Operationsverstärker 8 bildet die Regelabweichung des Spannungsregelkreises und verstärkt sie. Der invertierende Eingang des Operationsverstärkers 8 ist mit Bezugspotential verbunden, während dem nichtinvertierenden Eingang des Operationsverstärkers 8 über einen Widerstand 9 die Eingangsspannung $U_e$ sowie über einen Widerstand 10 die Ausgangsspannung $U_a$ zugeführt sind. Sind die Widerstandswerte der Widerstände 9 und 10 gleich groß, ist die Spannung zwischen dem nichtinvertierenden Eingang und dem invertierenden Eingang des Operationsverstärkers 8 praktisch Null, wenn die Ausgangsspannung $U_a$ der Schaltungsanordnung 1' gleich der negativen Eingangsspannung $U_e$ ist. In diesem Fall befindet sich der Operationsverstärker 8 in seinem Arbeitsbereich, d. h. die mit $U_1$ bezeichnete Ausgangsspannung des Operationsverstärkers 8 besitzt einen Wert, der zwischen der positiven Versorgungsspannung $+U_B$ und der negativen Versorgungsspannung $-U_B$ des Operationsverstärkers 8 liegt. Die Eingangsstufe für den Stromregelkreis enthält einen Operationsverstärker 11, der die Regelabweichung des Stromregelkreises bildet und sie verstärkt. Dem nichtinvertierenden Eingang des Operationsverstärkers 11 sind über einen Widerstand 12 die Eingangsspannung $U_e$ und über einen Widerstand 13 eine Spannung $U_4$ zugeführt. Die Spannung $U_4$ ist die Summe aus der Ausgangsspannung $U_a$ und der an dem Meßwiderstand $R_M$ abfallenden Spannung $R_M \times I_a$. Bezeichnet man die Widerstandswerte der Widerstände 12 und 13 mit $R_{12}$ bzw. $R_{13}$, so gilt für die Spannung $U_{11+}$ an dem nichtinvertierenden Eingang des Operationsverstärkers 11 die Beziehung

$$U_{11+} = \frac{U_e \times R_{13} + I_a \times R_M \times R_{12} + U_a \times R_{12}}{R_{12} + R_{13}} \quad .$$

Dem invertierenden Eingang des Operationsverstärkers 11 sind über einen Widerstand 14 Bezugspotential sowie über einen Widerstand 15 die Ausgangsspannung $U_a$ der Schaltungsanordnung 1' zugeführt. Bezeichnet man die Widerstandswerte der Widerstände 14 und 15 mit $R_{14}$ bzw. $R_{15}$, so gilt für die Spannung $U_{11-}$ an dem invertierenden Eingang des Operationsverstärkers 11 die Beziehung

$$U_{11-} = U_a \times \frac{R_{14}}{R_{14} + R_{15}} \quad .$$

Die Spannungsdifferenz zwischen dem nichtinvertierenden Eingang und dem invertierenden Eingang des Operationsverstärkers 11 ist Null, wenn die Spannung $U_{11+}$ gleich der Spannung $U_{11-}$ ist. In diesem Fall gilt

$$U_a \times \frac{R_{14}}{R_{14} + R_{15}} = \frac{U_e \times R_{13} + I_a \times R_M \times R_{12} + U_a \times R_{12}}{R_{12} + R_{13}} \; .$$

Wählt man das Verhältnis der Widerstandswerte der Widerstände 14 und 15 gleich dem Verhältnis der Widerstandswerte der Widerstände 12 und 13, so vereinfacht sich die obige Gleichung zu

$$I_a = - U_e \times \frac{R_{13}}{R_M \times R_{12}} \; .$$

Wenn diese Beziehung erfüllt ist, befindet sich der Operationsverstärker 11 in seinem Arbeitsbereich, d. h. die mit $U_2$ bezeichnete Ausgangsspannung des Operationsverstärkers 11 besitzt einen Wert, der zwischen der positiven Versorgungsspannung $+U_B$ und der negativen Versorgungsspannung $-U_B$ des Operationsverstärkers 11 liegt. In diesem Fall ist der Ausgangsstrom $I_a$ proportional der Eingangsspannung $U_e$.

In der Schaltungsanordnung 1' werden die Spannungen $U_4$ und $U_a$ an den Anschlüssen des Meßwiderstandes $R_M$ ebenso wie die Eingangsspannung $U_e$ den Eingängen des Operationsverstärkers 11 zugeführt. Der Operationsverstärker 11 subtrahiert die Spannung $U_a$ von der Spannung $U_4$ und bildet gleichzeitig durch Verknüpfen mit der Eingangsspannung $U_e$ die Regelabweichung des Stromregelkreises.

Der Ausgang des Operationsverstärkers 8 ist über zwei gleich große Widerstände 16 und 17 mit dem Ausgang des Operationsverstärkers 11 verbunden. Der Verbindungspunkt der Widerstände 16 und 17 ist mit dem Bezugszeichen 18 versehen. Die Spannung an dem Verbindungspunkt 18 ist mit $U_3$ bezeichnet. Sie ist der arithmetische Mittelwert der Spannungen $U_1$ und $U_2$. Die Widerstände 16 und 17 bilden eine Überlagerungsschaltung 19. Sie entspricht in ihrer Funktion der in der Figur 1 dargestellten Auswahlstufe 4.

Der Überlagerungsschaltung 19 ist ein Ausgangsverstärker 20 nachgeschaltet. Der Eingang des Ausgangsverstärkers 20 ist mit dem Bezugszeichen 21 versehen und sein Ausgang mit dem Bezugszeichen 22. Die Ausgangsspannung $U_3$ ist die Eingangsspannung des Ausgangsverstärkers 20. Die Spannung $U_4$ ist die Ausgangsspannung des Ausgangsverstärkers 20. Der Meßwiderstand $R_M$ ist dem Ausgangsverstärker 20 nachgeschaltet. Der Verbindungspunkt des Meßwiderstandes $R_M$ mit dem Lastwiderstand $R_L$ ist der Ausgang der Schaltungsanordnung 1'. Er ist mit dem Bezugszeichen 23 versehen.

Der Eingang 21 des Ausgangsverstärkers 20 ist über eine erste Z-Diode 24 mit der Basis eines pnp-Transistors 25 verbunden. Dessen Emitter ist über einen Widerstand 26 mit der positiven Versorgungsspannung $+U_B$ verbunden. Zwischen der Basis des pnp-Transistors 25 und der positiven Versorgungsspannung $+U_B$ ist ein Widerstand 27 angeordnet. Der Kollektor des pnp-Transistors 25 ist über eine Diode 28 mit dem Ausgang 22 des Ausgangsverstärkers 20 verbunden. Der Eingang 21 des Ausgangsverstärkers 20 ist über eine zweite Z-Diode 29 mit der Basis eines npn-Transistors 30 verbunden. Dessen Emitter ist über einen Widerstand 31 mit der negativen Versorgungsspannung $-U_B$ verbunden. Zwischen der Basis des npn-Transistors 30 und der negativen Versorgungsspannung $-U_B$ ist ein Widerstand 32 angeordnet. Der Kollektor des npn-Transistors 30 ist über eine Diode 33 mit dem Ausgang 22 des Ausgangsverstärkers 20 verbunden.

Der Spannungswert der Z-Dioden 24 und 29 ist im folgenden mit $U_z$ bezeichnet. Er ist so gewählt, daß er größer als der Betrag $U_B$ der Versorgungsspannung $-U_B$ bzw. $+U_B$ ist. Ist die Spannung $U_3$ negativ und ihr Betrag größer als der Betrag der Differenz zwischen den Spannungen $U_z$ und $U_B$ leitet der pnp-Transistor 25, der npn-Transistor 30 sperrt. Der Ausgangsstrom $I_a$ fließt von der positiven Versorgungsspannung $+U_B$ über den Widerstand 26, den pnp-Transistor 25, die Diode 28, den Meßwiderstand $R_M$ und den Lastwiderstand $R_L$. An dem Lastwiderstand $R_L$ fällt die Spannung $U_a = R_L \times I_a$ ab. Ist die Spannung $U_3$ dagegen positiv und größer als der Betrag der Differenz zwischen den Spannungen $U_z$ und $U_B$ leitet der npn-Transistor 30, der pnp-Transistor 25 sperrt. Der Ausgangsstrom $I_a$ fließt jetzt in entgegengesetzter Richtung über den Lastwiderstand $R_L$, den Meßwiderstand $R_M$, die Diode 33, den npn-Transistor 30 und den Widerstand 31 zu der negativen Versorgungsspannung $-U_B$. An dem Lastwiderstand $R_L$ fällt die Spannung $U_a = R_L \times I_a$ ab.

Ob der Stromregelkreis oder der Spannungsregelkreis dominiert, hängt davon ab, welcher Operationsverstärker 8 oder 11 sich in seinem Arbeitsbereich befindet. Bei einem kleinen Lastwiderstand $R_L$ erreicht der Ausgangsstrom $I_a$ den durch die Eingangsspannung $U_e$ vorgegebenen Sollwert bevor die Ausgangsspannung $U_a$ den durch die Eingangsspannung $U_e$ vorgegebenen Sollwert erreicht hat. Die Ausgangsspannung $U_2$ des dem Stromregelkreis zugeordneten Operationsverstärkers 11 befindet sich daher in ihrem Arbeitsbereich, liegt also zwischen der negativen Versorgungsspannung $-U_B$ und der positiven Versorgungsspannung $+U_B$. Dagegen ist der dem Spannungsregelkreis zugeordnete Operationsverstärkers 8 ständig übersteuert, da die als Istwertsignal dienende Ausgangsspannung $U_a$ betragsmäßig kleiner als die als Sollwertsignal dienende Eingangsspannung $U_e$ ist. Die Ausgangsspannung $U_1$ des Operationsverstärkers 8 ist daher für negative Werte der Eingangsspannung $U_e$ die negative Versorgungsspannung $-U_B$. Da die Ausgangsspannung $U_1$ des Operationsverstärkers 8 konstant ist, bewirkt sie nur eine Verschiebung der als Eingangsspannung für den Ausgangsverstärker 20 dienenden Spannung $U_3$ um einen konstanten Wert. Die Spannung $U_3$ ändert sich daher nur entsprechend der Ausgangsspannung $U_2$ des Operationsverstärkers 11. Das Ausgangssignal der Schaltungsanordnung 1' wird nur von dem Stromregelkreis beeinflußt, der Spannungsregelkreis ist unwirksam. Für positive Werte der Eingangsspannung $U_e$ ist die Ausgangsspannung $U_1$ des Operationsverstärkers 8 die positive Versorgungsspannung $+U_B$. Da die Ausgangsspannung $U_1$ des Operationsverstärkers 8 auch in diesem Fall konstant ist, ändert sich die als Eingangsspannung für den Ausgangsverstärker 20 dienende Spannung $U_3$ nur entsprechend der Ausgangsspannung $U_2$ des Operationsverstärkers 11. Das Ausgangssignal der Schaltungsanordnung 1' wird deshalb ebenfalls nur von dem Stromregelkreis beeinflußt, der Spannungsregelkreis bleibt unwirksam.

Bei einem großen Lastwiderstand $R_L$ erreicht die Ausgangsspannung $U_a$ den durch die Eingangsspannung $U_e$ vorgegebenen Sollwert bevor der Ausgangsstrom $I_a$ den durch die Eingangsspannung $U_e$ vorgegebenen Sollwert erreicht hat. Die Ausgangsspannung $U_1$ des dem Spannungsregelkreis zugeordneten Operationsverstärkers 8 befindet sich daher in ihrem Arbeitsbereich, liegt also zwischen der negativen Versorgungsspannung $-U_B$ und der positiven Versorgungsspannung $+U_B$. Dagegen ist der dem Stromregelkreis zugeordnete Operationsverstärkers 11 ständig übersteuert, da der als Istwertsignal dienende Spannungsabfall an dem Meßwiderstand $R_M$ betragsmäßig kleiner als die als Sollwertsignal dienende Eingangsspannung $U_e$ ist. Die Ausgangsspannung $U_2$ des Operationsverstärkers 11 ist daher für negative Werte der Eingangsspannung $U_e$ die negative Versorgungsspannung $-U_B$. Da die Ausgangsspannung $U_2$ des Operationsverstärkers 11 konstant ist, bewirkt sie nur eine Verschiebung der als Eingangsspannung für den Ausgangsverstärker 20 dienenden Spannung $U_3$ um einen konstanten Wert. Die Spannung $U_3$ ändert sich daher nur entsprechend der Ausgangsspannung $U_1$ des Operationsverstärkers 8. Das Ausgangssignal der Schaltungsanordnung 1' wird nur von dem Spannungsregelkreis beeinflußt, der Stromregelkreis ist unwirksam. Für positive Werte der Eingangsspannung $U_e$ ist die Ausgangsspannung $U_2$ des Operationsverstärkers 11 die positive Versorgungsspannung $+U_B$. Da die Ausgangsspannung $U_2$ des Operationsverstärkers 11 auch in diesem Fall konstant ist, ändert sich die als Eingangsspannung für den Ausgangsverstärker 20 dienende Spannung $U_3$ nur entsprechend der Ausgangsspannung $U_1$ des Operationsverstärkers 8. Das Ausgangssignal der Schaltungsanordnung 1' wird deshalb ebenfalls nur von dem Spannungsregelkreis beeinflußt, der Stromregelkreis bleibt unwirksam.

Bei der in der Figur 3 dargestellten Schaltungsanordnung 1" handelt es sich um die in der Figur 2 dargestellte Schaltungsanordnung 1', die durch zusätzliche Bauelemente erweitert ist. Der invertierende Eingang des Operationsverstärkers 8 ist nicht - wie in der Figur 2 dargestellt - direkt mit Bezugspotential verbunden sondern über einen Widerstand 34. Außerdem ist der Ausgang des Operationsverstärkers 8 über einen Kondensator 35 mit seinem invertierenden Eingang verbunden. Der nichtinvertierende Eingang des Operationsverstärkers 8 ist über einen weiteren Kondensator 36 mit dem Ausgang 22 des Ausgangsverstärkers 8 verbunden. Der Ausgang des Operationsverstärkers 11 ist über einen Kondensator 37 mit seinem invertierenden Eingang verbunden. Diese zusätzlichen Bauelemente dienen zur Dämpfung von Eigenschwingungen der Schaltungsanordnung 1", die u. a. von Verzögerungen der Transistoren 25 und 30 des Ausgangsverstärkers 20 verursacht werden. Zwischen dem Ausgang 23 der Schaltungsanordnung 1" und Bezugspotential ist ein Kondensator 38 angeordnet. Dieser Kondensator glättet die Ausgangsspannung $U_a$ der Schaltungsanordnung 1".

## Patentansprüche

1. Elektrische Schaltungsanordnung zur Umformung einer Eingangsspannung in eine eingeprägte elektrische Ausgangsgröße, wobei zwischen Eingangsspannung und elektrischer Ausgangsgröße eine vorgegebene Zuordnung besteht, insbesondere Sollwertgeber für hydraulische Stetigventile mit integrierter Ansteuerelektronik,

   - wobei zwei Regeleinrichtungen mit getrennten Eingangsstufen (2, 3) und mit einer gemeinsamen Ausgangsstufe (5) vorgesehen sind, denen die Eingangsspannung ($U_e$) der Schaltungsanordnung (1) als Sollwertsignal zugeführt ist,
   - wobei der Eingangsstufe (2) der ersten Regeleinrichtung ein der Ausgangsspannung ($U_a$) der Schaltungsanordnung (1) entsprechendes Istwertsignal zugeführt ist,
   - wobei der Eingangsstufe (3) der zweiten Regeleinrichtung ein dem Ausgangsstrom ($I_a$) der Schaltungsanordnung (1) entsprechendes Istwertsignal zugeführt ist,
   - wobei diejenige Regeleinrichtung, an deren Eingangsstufe (2, 3) die kleinere Regelabweichung ansteht, das Ausgangssignal der Schaltungsanordnung (1) bestimmt,

- wobei die beiden Eingangsstufen jeweils einen Operationsverstärker (8, 11) enthalten, der die jeweilige Regelabweichung bildet und verstärkt,
- wobei die Ausgangsspannungen ($U_1$, $U_2$) der beiden Operationsverstärker (8, 11) einer Auswahlschaltung (19) zugeführt sind,
- wobei der Auswahlschaltung (19) ein Ausgangsverstärker (20) nachgeschaltet ist und
- wobei die elektrische Ausgangsgröße (Ua, $I_a$) einer Last ($R_L$) zugeführt ist,

**dadurch gekennzeichnet,**

- **daß** der Ausgang des Ausgangsverstärkers (20) über einen ersten Widerstand ($R_M$) mit einem Anschluß der Last ($R_L$) verbunden ist und der andere Anschluß der Last ($R_L$) mit Bezugspotential verbunden ist,
- **daß** dem nichtinvertierenden Eingang des ersten Operationsverstärkers (8) über einen zweiten Widerstand (9) die Eingangsspannung ($U_e$) der Schaltungsanordnung (1', 1") sowie über einen dritten Widerstand (10) die Ausgangsspannung ($U_a$) der Schaltungsanordnung (1', 1") zugeführt sind,
- **daß** dem invertierenden Eingang des ersten Operationsverstärkers (8) Bezugspotential zugeführt ist,
- **daß** dem nichtinvertierenden Eingang des zweiten Operationsverstärkers (11) über einen vierten Widerstand (12) die Eingangsspannung ($U_e$) der Schaltungsanordnung (1', 1") sowie über einen fünften Widerstand (13) die Ausgangsspannung ($U_4$) des Ausgangsverstärkers (20) zugeführt sind und
- **daß** dem invertierenden Eingang des zweiten Operationsverstärkers (11) über einen sechsten Widerstand (14) Bezugspotential sowie über einen siebten Widerstand (15) die Ausgangsspannung ($U_a$) der Schaltungsanordnung (1', 1") zugeführt sind.

2. Schaltungsanordnung nach Anspruch 1, **dadurch gekennzeichnet,**

- **daß** der invertierende Eingang des ersten Operationsverstärkers (8) über einen ersten Kondensator (35) mit dem Ausgang des ersten Operationsverstärkers (8) sowie über einen vierzehnten Widerstand (34) mit Bezugspotential verbunden ist,
- **daß** der nichtinvertierende Eingang des ersten Operationsverstärkers (8) über einen zweiten Kondensator (36) mit dem Ausgang (22) des Ausgangsverstärkers (20) verbunden ist,
- **daß** der invertierende Eingang des zweiten Operationsverstärkers (11) über einen dritten Kondensator (37) mit dem Ausgang des zweiten Operationsverstärkers (11) verbunden ist und
- **daß** zwischen dem Ausgang (23) der Schaltungsanordnung (1', 1") und Bezugspotential ein vierter Kondensator (38) angeordnet ist.

3. Schaltungsanordnung nach Anspruch 1 oder Anspruch 2, **dadurch gekennzeichnet, daß** das Verhältnis des Widerstandswertes des sechsten Widerstandes (14) zu dem Widerstandswert des siebten Widerstandes (15) gleich dem Verhältnis des Widerstandswertes des vierten Widerstandes (12) zu dem Widerstandswert des fünften Widerstandes (13) ist.

4. Schaltungsanordnung nach einem der vorhergehenden Ansprüche, **dadurch gekennzeichnet,**

- **daß** der Ausgang des ersten Operationsverstärkers (8) über einen achten Widerstand (16) und einen neunten Widerstand (17) mit dem Ausgang des zweiten Operationsverstärkers (11) verbunden ist und
- **daß** der gemeinsame Schaltungspunkt (18) des achten Widerstandes (16) und des neunten Widerstandes (17) mit dem Eingang (21) des Ausgangsverstärkers (20) verbunden ist.

5. Schaltungsanordnung nach Anspruch 4, **dadurch gekennzeichnet,**

- **daß** der Eingang (21) des Ausgangsverstärkers (20) über eine erste Z-Diode (24) mit der Basis eines pnp-Transistors (25) und über eine zweite Z-Diode (29) mit der Basis eines npn-Transistors (30) verbunden ist,
- **daß** der Emitter des pnp-Transistors (25) über einen zehnten Widerstand (26) mit der positiven Versorgungsspannung (+$U_B$) verbunden ist,
- **daß** zwischen der Basis des pnp-Transistors (25) und der positiven Versorgungsspannung (+$U_B$) ein elfter Widerstand (27) angeordnet ist,
- **daß** der Emitter eines npn-Transistors (30) über einen zwölften Widerstand (31) mit der negativen Versorgungsspannung (-$U_B$) verbunden ist,
- **daß** zwischen der Basis des npn-Transistors (30) und der negativen Versorgungsspannung (-$U_B$) ein dreizehnter Widerstand (32) angeordnet ist,

- **daß** der Kollektor des pnp-Trarrsistors (25) und der Kollektor des npn-Transistors (30) über die Reihenschaltung von zwei jeweils in Flußrichtung angeordneten Dioden (28, 33) verbunden sind und
- **daß** der gemeinsame Schaltungspunkt (22) der beiden Dioden (28, 33) der Ausgang des Ausgangsverstärkers (20) ist.

**Claims**

1. An electrical circuit arrangement for conversion of an input voltage into an impressed electrical output variable, there being a predetermined assignment between input voltage and electrical output variable, in particular setpoint generators for hydraulic continuous-control valves with integrated control electronics,

   - wherein two regulating devices having separate input stages (2, 3) and a common output stage (5) are provided, to which devices the input voltage ($U_e$) of the circuit arrangement (1) is fed as a setpoint signal,
   - wherein the input stage (2) of the first regulating device is fed an actual value signal corresponding to the output voltage ($U_a$) of the circuit arrangement (1),
   - wherein the input stage (3) of the second regulating device is fed an actual value signal corresponding to the output current ($I_a$) of the circuit arrangement (1),
   - wherein that regulating device at whose input stage (2, 3) the smaller control deviation is present determines the output signal of the circuit arrangement (1),
   - wherein the two input stages each contain an operational amplifier (8, 11) which generates and amplifies the respective control deviation,
   - wherein the output voltages ($U_1$, $U_2$) of the two operational amplifiers (8, 11) are fed to a selector circuit (19),
   - wherein an output amplifier (20) is connected in series after the selector circuit (19), and
   - wherein the electrical output variable ($U_a$, $I_a$) is fed to a load ($R_L$),

   **characterized by** the fact that

   - the output of the output amplifier (20) is connected via a first resistor ($R_M$) to one connection of the load ($R_L$) and the other connection of the load ($R_L$) is connected to reference potential,
   - that the input voltage ($U_e$) of the circuit arrangement (1', 1'') is fed via a second resistor (9) and the output voltage ($U_a$) of the circuit arrangement (1', 1'') is fed via a third resistor (10) to the non-inverting input of the first operational amplifier (8),
   - that reference potential is fed to the inverting input of the first operational amplifier (8),
   - that the input voltage ($U_e$) of the circuit arrangement (1', 1 ") is fed via a fourth resistor (12) and the output voltage ($U_4$) of the output amplifier (20) is fed via a fifth resistor (13) to the non-inverting input of the second operational amplifier (11), and
   - that, the reference potential is fed via a sixth resistor (14) and the output voltage ($U_a$) of the circuit arrangement (1', 1'') via a seventh resistor (15) to the inverting input of the second operational amplifier (11).

2. A circuit arrangement according to claim 1, **characterized by** the fact that

   - the inverting input of the first operational amplifier (8) is connected via a first capacitor (35) with the output of the first operational amplifier (8) and, via a fourteenth resistor (34), to reference potential,
   - that the non-inverting input of the first operational amplifier (8) is connected via a second capacitor (36) to the output (22) of the output amplifier (20),
   - that the inverting input of the second operational amplifier (11) is connected via a third capacitor (37) to the output of the second operational amplifier (11), and
   - that between the output (23) of the circuit arrangement (1', 1 ") and reference potential there is arranged a fourth capacitor (38).

3. A circuit arrangement according to claim 1 or claim 2, **characterized by** the fact that the ratio of the resistance value of the sixth resistor (14) to the resistance value of the seventh resistor (15) is equal to the ratio of the resistance value of the fourth resistor (12) to the resistance value of the fifth resistor (13).

4. A circuit arrangement according to any of the preceding claims, **characterized by** the fact that

   - the output of the first operational amplifier (8) is connected via an eighth resistor (16) and a ninth resistor (17) to the output of the second operational amplifier (11), and
- that the common switching point (18) of the eighth resistor (16) and the ninth resistor (17) is connected to the input (21) of the output amplifier (20).

**5.** A circuit arrangement according to claim 4, **characterized by** the fact that

- the input (21) of the output amplifier (20) is connected via a first Zener diode (24) to the base of a PNP transistor (25) and via a second Zener diode (29) to the base of a NPN transistor (30),
- that the emitter of the PNP transistor (25) is connected via a tenth resistor (26) to the positive supply voltage $(+U_B)$,
- that between the base of the PNP transistor (25) and the positive supply voltage $(+U_B)$ there is arranged an eleventh resistor (27),
- that the emitter of a NPN transistor (30) is connected via a twelfth resistor (31) to the negative supply voltage $(-U_B)$,
- that between the base of the NPN transistor (30) and the negative supply voltage $(-U_B)$ there is arranged a thirteenth resistor (32),
- that the collector of the PNP transistor (25) and the collector of the NPN transistor (30) are connected via the series connection of two diodes (28, 33) arranged in each case in the direction of flow, and
- that the common switching point (22) of the two diodes (28, 33) is the output of the output amplifier (20).

## Revendications

**1.** Un dispositif de commutation électrique destiné à la transformation d'une tension d'entrée en une grandeur de sortie électrique déterminée, cependant qu'un rapport donné règne entre la tension d'entrée et la grandeur de sortie électrique, en particulier un émetteur de consigne pour des valves hydrauliques progressives dotées d'électronique de commande intégrée,

- cependant que sont prévus deux dispositifs d'asservissement dotés d'étages (2, 3) d'entrée distincts et dotés d'un étage (5) de sortie commun, vers lesquels est ramenée pour signal de consigne la tension $(U_e)$ d'entrée du dispositif (1) de commutation,
- cependant qu'un signal de valeur réelle, correspondant à la tension $(U_a)$ de sortie du dispositif (1) de commutation, est ramené vers l'étage (2) d'entrée du premier dispositif d'asservissement,
- cependant qu'un signal de valeur réelle correspondant au courant $(I_a)$ de sortie du dispositif (1) de commutation est ramené vers l'étage (3) d'entrée du second dispositif d'asservissement,
- cependant que celui des dispositifs d'asservissement, où l'écart de réglage au niveau de l'étage (2, 3) d'entrée est le plus faible, détermine le signal de sortie du dispositif (1) de commutation,
- cependant que chacun des deux étages d'entrée comportent un amplificateur (8, 11) opérationnel, qui forme et amplifie l'écart de réglage correspondant,
- cependant que les tensions $(U_1, U_2)$ de sortie des deux amplificateurs (8, 11) opérationnels sont ramenées vers un branchement (19) de sélection,
- cependant qu'un amplificateur (20) de sortie est branché en aval du branchement (19) de sélection et
- cependant que la grandeur $(U_a, I_a)$ de sortie est ramenée vers une charge $(R_L)$,

**caractérisé en ce**

- **que** la sortie de l'amplificateur (20) de sortie est raccordée par une première résistance $(R_M)$ à un raccord de la charge $(R_L)$ et l'autre raccord de la charge $(R_L)$ est relié au potentiel de référence,
- **que** la tension $(U_e)$ d'entrée du dispositif (1', 1 ") de commutation, en passant par une deuxième résistance (9), ainsi que la tension $(U_a)$ de sortie du dispositif (1', 1") de commutation, en passant par une troisième résistance (10), sont ramenées vers l'entrée non invertissante du premier amplificateur (8) opérationnel,
- **que** le potentiel de référence est ramené vers l'entrée invertissante du premier amplificateur (8) opérationnel,
- **que** la tension $(U_e)$ d'entrée du dispositif (1', 1'') de commutation, en passant par une quatrième résistance (12), ainsi que la tension $(U_4)$ de sortie de l'amplificateur (20) de sortie, en passant par une cinquième résistance (13), sont ramenées vers l'entrée non invertissante du second amplificateur (11) opérationnel et
- **que** le potentiel de référence, en passant par une sixième résistance (14), ainsi que la tension $(U_a)$ de sortie du dispositif (1', 1") de commutation, en passant par une septième résistance (15), sont ramenés vers l'entrée invertissante du second amplificateur (11) opérationnel.

**2.** Un dispositif de commutation selon la revendication n° 1, **caractérisé en ce**

- **que** l'entrée invertissante du premier amplificateur (8) opérationnel est raccordée à la sortie du premier amplificateur (8) opérationnel, par un premier condensateur (35), et au potentiel de référence, par une quatorzième résistance (34),
- **que** l'entrée non invertissante du premier amplificateur (8) opérationnel est raccordée à la sortie (22) de l'amplificateur (20) de sortie, par un deuxième condensateur (36),
- **que** l'entrée invertissante du second amplificateur (11) opérationnel est raccordée à la sortie du second amplificateur (11) opérationnel, par un troisième condensateur (37), et
- **qu'**un quatrième condensateur (38) est disposé entre la sortie (23) du dispositif (1', 1'') de commutation et le potentiel de référence.

**3.** Un dispositif de commutation selon la revendication n° 1 ou la revendication n° 2, **caractérisé en ce que** le rapport entre la valeur de résistance de la sixième résistance (14) et la valeur de résistance de la septième résistance (15) égale le rapport entre la valeur de résistance de la quatrième résistance (12) et la valeur de résistance de la cinquième résistance (13).

**4.** Un dispositif de commutation selon une des revendications précédentes, **caractérisé en ce**

- **que** la sortie du premier amplificateur (8) opérationnel est raccordée à la sortie du second amplificateur (11) opérationnel, par une huitième résistance (16) et par une neuvième résistance (17), et
- **que** le point (18) de branchement commun à la huitième résistance (16) et à la neuvième résistance (17) est raccordé à l'entrée (21) de l'amplificateur (20) de sortie.

**5.** Un dispositif de commutation selon la revendication n° 4, **caractérisé en ce**

- **que** l'entrée (21) de l'amplificateur (20) de sortie est raccordée à la base d'un transistor (25) PNP, par une première diode (24) de Zener, et à la base d'un transistor (30) NPN, par une seconde diode (29) de Zener,
- **que** l'émetteur du transistor (25) PNP est raccordé à la tension (+UB) d'alimentation positive, par une dixième résistance (26),
- **qu'**une onzième résistance (27) est disposée entre la base du transistor (25) PNP et la tension (+UB) d'alimentation positive,
- **que** l'émetteur d'un transistor (30) NPN est raccordé à la tension (-UB) d'alimentation négative, par une douzième résistance (31),
- **qu'**une treizième résistance (32) est disposée entre la base du transistor (30) NPN et la tension (-UB) d'alimentation négative,
- **que** le collecteur du transistor (25) PNP et le collecteur du transistor (30) NPN sont raccordés par le branchement en série de deux diodes (28, 33), qui à tout instant sont disposées dans le sens du flux, et
- **que** le point (22) de branchement commun aux deux diodes (28, 33) est la sortie de l'amplificateur (20) de sortie.

FIG.1

FIG.2

FIG. 3

EP 0 779 702 B1